# EUROPÄISCHE PATENTSCHRIFT

(11) **EP 2 478 266 B1**
(45) Veröffentlichungstag und Bekanntmachung des Hinweises auf die Patenterteilung: **07.09.2016**
(21) Anmeldenummer: 10735200.7
(22) Anmeldetag: 13.07.2010
(51) Int. Cl.: F16H 61/00

(54) **KONTAKTIERUNGSMODUL FÜR EINE GETRIEBESTEUERUNG, GETRIEBESTEUERUNGSMODUL UND VERFAHREN ZU DEREN HERSTELLUNG**
CONTACTING MODULE FOR A TRANSMISSION CONTROLLER, TRANSMISSION CONTROL MODULE, AND METHOD FOR THE PRODUCTION THEREOF
MODULE DE MISE EN CONTACT POUR UNE COMMANDE DE BOÎTE DE VITESSES, MODULE DE COMMANDE DE BOÎTE DE VITESSES ET LEUR PROCÉDÉ DE FABRICATION

(30) Priorität: 16.09.2009 DE 102009041756
(43) Veröffentlichungstag der Anmeldung: 25.07.2012
(73) Patentinhaber: WABCO GmbH, 30453 Hannover (DE)
(72) Erfinder: BRAMMER, Christian, 29303 Bergen (DE)
(74) Vertreter: Lauerwald, Jörg
(86) Internationale Anmeldenummer: PCT/EP2010/004242
(87) Internationale Veröffentlichungsnummer: WO 2011/032615

(56) Entgegenhaltungen:
- EP-A2- 1 186 478
- DE-A1-102004 062 679
- DE-A1-102006 050 429
- JP-A- 2004 208 465

## Beschreibung

Die Erfindung betrifft ein Kontaktierungsmodulsmodul für eine Getriebesteuerung, das zur Kontaktierung von Magnetventilen und einem elektronischen Steuergerät, vorzugsweise auch von Sensoren dient. Weiterhin betrifft die Erfindung ein Herstellungsverfahren für ein derartiges Kontaktierungsmodul und ein Getriebesteuerungsmodul mit einem derartigen Kontaktierungsmodul, sowie ein Verfahren zum Herstellen des Getriebesteuerungsmoduls.

Derartige Kontaktierungsmodule dienen als Teile von Getriebesteuerungen dazu, die vielfältigen komplexen Kontaktierungen zu übernehmen. Hierbei wird das elektronische Steuergerät mit den jeweiligen anzusteuernden Magnetventilen sowie im allgemeinen Sensoren, z.B. Beschleunigungssensoren, Drehratensensoren, Drucksensoren kontaktiert.

Die Kontaktierungsmodule werden im Allgemeinen mit einem Kunststoffgehäuse und einem Leitungsträger ausgebildet, der wiederum als Flexfolie oder Stanzgitter ausgebildet ist. Flexfolien werden hierbei im Allgemeinen gelötet oder geschweißt. Stanzgitter werden herkömmlicherweise über Steckkontakte kontaktiert.

Derartige Kontaktierungen sind jedoch im Allgemeinen nicht unproblematisch. Lötverbindungen neigen bei mechanischen Belastungen, insbesondere mechanischen Mikrobewegungen, zur Zerrüttung und somit zum Ausfall. Steckverbindungen verschleißen bei mechanischen Mikrobewegungen, so dass sich eine Oxidschicht bilden kann und der ohmsche Widerstand der Kontaktierung steigt, so dass gegebenenfalls Sensorsignale beeinflusst und verfälscht werden können und gegebenenfalls unerwünschte Kontaktunterbrechungen auftreten können.

DE 10 2006 050 429 A1 offenbart eine Vorrichtung zum Anschließen an einen Getriebesteller eines Motorgetriebes mit Sensoren zum Sensieren von Getriebeschaltpositionen einer Schaltvorrichtung und eine Schnittstelle zur Übermittlung der Auswertesignale der Sensoren an die Steuerelektronik eines Gebtriebestellers, wobei die Sensoren derart angeordnet sind, dass ihr Abstand zur Scnittstelle geringer ist als der Abstand zwischen der Schnittstelle und der zu sensierenden Schaltvorrichtung.

Der Erfindung liegt daher die Aufgabe zugrunde, ein Kontaktierungsmodul und ein Getriebesteuerungsmodul mit einem derartigen Kontaktierungsmodul zu schaffen, die zum einen mit retativ geringem Aufwand herstellbär sind und dennoch eine sichere Kontaktierung auch bei höheren oder komplexeren mechanischen Belastungen ermöglichen.

Diese Aufgabe wird durch ein Kontaktierungsmodul nach Anspruch 1 sowie ein Getriebesteuerungsmodul nach Anspruch 12 gelöst. Weiterhin sind Verfahren zur Herstellung des erfindungsgemäßen Kontaktierungsmoduls und des Getriebesteuerungsmoduls vorgesehen. Die Unteransprüche beschreiben bevorzugte Weiterbildungen.

Erfindungsgemäß sind somit im Modulgehäuse in vertikaler Richtung verlaufende Freiräume ausgebildet, in denen die freien Enden des Stanzgitters oder zumindest einige der freien Enden des Stanzgitters aufgenommen sind. Die freien Enden können hierbei insbesondere in vertikaler Richtung, d.h. nach oben oder unten, aus dem Modulgehäuse hervorragen zur Kontaktierung mit entsprechenden Kontaktzungen der relevanten Komponenten, d.h. der Magnetventilen und gegebenenfalls Sensoren. Hierbei kann z.B. das Kontaktierungsmodul auf das Steuerungsgehäuse mit den vormontierten Komponenten aufgesetzt werden, so dass die Kontaktzungen der Komponenten durch die vertikalen Freiräume gelangen und etwas lateral beabstandet zu den Kontaktflächen der freien Enden des Stanzgitters verbleiben, so dass Kontaktzungen der Komponenten und die freien Enden des Stanzgitter nachfolgend durch z.B. ein Widerstandsschweißgerät zusammengedrückt und miteinander kontaktiert werden können.

Erfindungsgemäß sind die freien Enden hierbei derartig, elastisch nachgiebig, dass sie zum einen leicht mit den Kontäktzungen kontaktiert werden können und weiterhin bei den auftretenden Bewegungen, insbesondere den Mikrobewegungen, elastisch nachgiebig sind und somit die Bewegungen auffangen, so dass die Kontaktierungen, d.h. z.B. die Schweißverbindungen, nicht belastet werden. Hierbei kann insbesondere eine Konturierung der freien Enden mit gebogenem und/oder gekrümmtem Verlauf der Leiterbahnen vorgesehen sein.

Das Gehäuse kann vorteilhafterweise zweischalig ausgebildet sein mit einer Oberschale und einer Unterschale, die miteinander verrasten, z.B. verklipsen, gegebenenfalls auch verschweißt, verstemmt, verprägt oder vernietet werden. Hierbei werden die beiden Schalen auch durch die Befestigung des Gehäuses an dem Steuerungsgehäuse und den Komponenten über entsprechende Schrauben zusammen gehalten. Bei einer derartigen zweischaligen Ausbildung kann somit das Stanzgitter zunächst in eine der Schälen, z.B. die Oberschale gelegt und z.B. durch Verprägen fixiert werden, und nachfolgend die andere Schale aufgesetzt werden, wobei die freien Enden in den Freiräumen aufgenommen sind und vorteilhafterweise nach oben herausragen. Das so kostengünstig und schnell ausgebildete Kontaktierungsmodul ermöglicht nachfolgend eine sichere Kontaktierung, die den auftretenden mechanischen Belastungen, insbesondere auch Mikrobewegungen, Stand hält. Hierzu kann ein Schweißgerät die zu kontaktierenden Partner in den Freiräumen oder oberhalb der Freiräume sukzessive anfahren und kontaktieren.

Die Erfindung wird im Folgenden anhand der beiliegenden Zeichnungen an einer Ausführungsform näher erläutert. Es zeigen:
- Fig. 1: ein erfindungsgemäßes Kontaktierungsmodul bei Befestigung auf einem Steuerungsgehäuse;
- Fig. 2: eine auseinander gezogene Darstellung des Kontaktierungsmoduls;
- Fig. 3, 4: Ausschnitte aus dem Kontaktierungsmodul mit den freien Enden des Stanzgitters und Freiräumen des Modulgehäuses, jeweils als Innenansicht des Modulgehäuses;
- Fig. 5: einen Ausschnitt aus einer Seitenansicht des Modulgehäuses im Bereich eines freien Endes des Stanzgitters;
- Fig. 6: einen Ausschnitt aus dem erfindungsgemäßen Getriebesteuerungsmodul im Bereich einer Kontaktierung eines freien Endes des Stanzgitters.

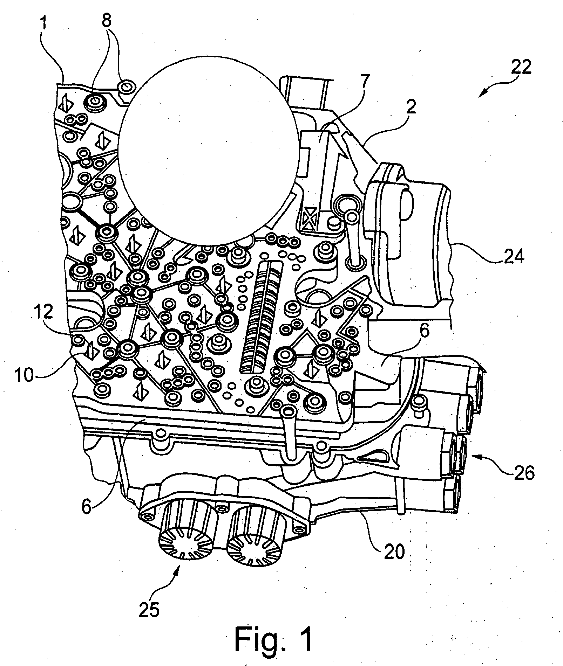

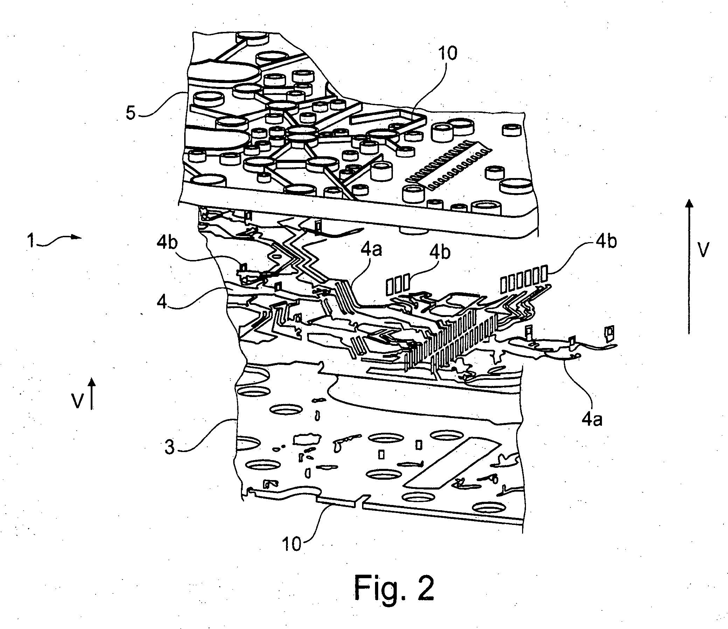

Ein erfindungsgemäßes Kontaktierungsmodul 1 ist in Fig. 2 in auseinander gezogener Darstellung bzw. Explosionsdarstellung gezeigt und in Fig. 1 auf einem Steuerungsgehäuse 2 befestigt. Das Kontaktierungsmodul 1 weist gemäß Fig. 2 eine untere Schale 3, ein Stanzgitter 4 und eine obere Schale 5 auf. Die Schalen 3, 5 sind jeweils als Kunststoffteile, z.B. Spritzgussteile ausgebildet und miteinander verrastet oder verklipst, so dass sie das metallische Stanzgitter 4 sicher zwischen sich aufnehmen.

Das Stanzgitter 4 wird in an sich bekannter Weise durch Ausstanzen aus einem Metallblech, z.B. aus Bronze, hergestellt und weist Leiterbahnen 4a und freie Enden 4b auf, die zur Kontaktierung dienen und untereinander über die Leiterbahnen 4a verbunden sind. Das gesamte Kontaktierungsmodul 1 dient zur wechselseitigen Kontaktierung der angeschlossenen Komponenten, insbesondere Sensoren 7, z.B. Drucksensoren oder Wegsensoren, und Magnetventilen 6 sowie einem hier nicht gezeigten Steuergerät. In Fig. 1 ist die Befestigung des zusammengesetzten Kontaktierungsmoduls 1 auf dem Steuerungsgehäuse 2 gezeigt, wobei das Kontaktierungsmodul 1 sowohl mit den Magnetventilen 6 und gegebenenfalls Sensoren 7 als auch mit dem Steuerungsgehäuse 2 über Schrauben 8 verbunden ist. Weiterhin erfolgt eine Zwischenkontaktierung über die freien Enden 4b des Stanzgitters 4 mit entsprechenden Kontaktzungen der Komponenten 6, 7, wie nachfolgend erläutert wird.

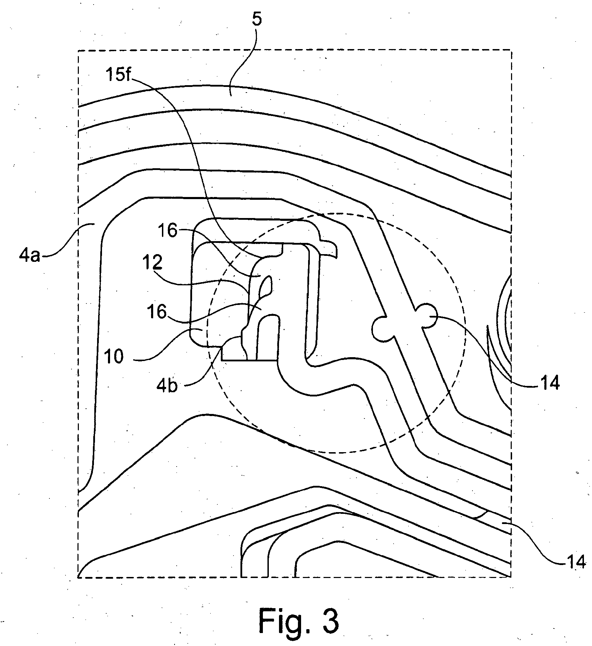

Erfindungsgemäß sind in den beiden Schalen 3, 5 Freiräume 10 ausgebildet, die miteinander fluchten und somit sich in vertikaler Richtung V - die der Montagerichtung entspricht - durchgängige Freiräume 10 bilden. Die Leiterbahnen 4a des Stanzgitters 4 verlaufen im Wesentlichen innerhalb der horizontalen Ebene, wobei die freien Enden 4b abgewinkelt sind und die Kontaktflächen 12 der freien Enden 4b wiederum in vertikaler Richtung V oder gegebenenfalls auch teilweise etwas abgewinkelt hierzu ausgebildet sind, wie mit Bezug zu Fig. 3, 4, 5, 6 detailliert gezeigt ist. Hierbei sind die freien Enden 4b ganz oder überwiegend in den durchgängigen Freiräumen 10 aufgenommen und verlaufen somit in vertikaler Richtung in den Freiräumen 10 der oberen Schale 5 bzw. ragen auch durch diese hindurch. Die freien Enden 4b weisen hierbei eine erfindungsgemäße Konturierung auf, die nachfolgend erläutert wird.

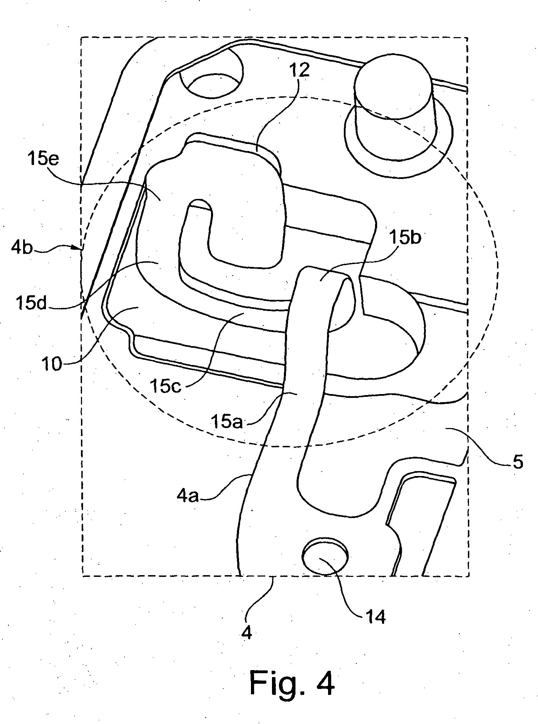

Fig. 3 und 4 zeigen Innenansichten des Kontaktierungsmoduls 1 bzw. Ansichten auf die untere Seite der oberen Schale 5, nachdem das Stanzgitter 4 dort eingesetzt worden ist und vor dem Verbinden mit der unteren Schale 3 .An der Unterseite bzw. Innenseite der oberen Schale 5 sind Prägestifte (Kunststoffnoppen) als Fixierungsbereiche 14 ausgebildet, die bei oder nach dem Einsetzen des Stanzgitters 4 mechanisch verprägt werden, z.B. gemäß Fig. 4 in Augen des Stanzgitters 4 oder gemäß Fig. 3 beidseitig der Leiterbahnen 4a, so dass nach dem mechanischen Verprägen oder Verformen das Stanzgitter 4 in der oberen Schale 5 fixiert ist. Die Prägestifte dienen somit als Fixierungsbereiche 14 und sind von den freien Enden 4b beabstandet, so dass diese flexibel verstellbar sind.

Die freien Enden 4b sind erfindungsgemäß aufgrund ihrer Konturierung elastisch nachgiebig bzw. flexibel verstellbar, vorteilhafterweise in sämtlichen drei Raumrichtungen. Somit kann das Stanzgitter 4 durch die flexible Einbettung in den beiden Schalen bzw. Halbschalen 3, 5 Toleranzen in alle Raumrichtungen ausgleichen. Weiterhin wird durch diese Anbindung die Übertragung von Relativbewegungen aus den fest eingebetteten Bereichen um die Fixierungen 14 reduziert. Da das Stanzgitter 4 mit seinen Leiterbahnen 4a nicht mehr großflächig in dem zweischaligen Gehäuse 3, 5 fixiert ist, sondern lediglich in den Fixierungsbereichen 14 fixiert ist, ist die direkte Übertragung der auf das Gehäuse 3, 5 eingeleiteten Schwingungen bis in die freien Enden 4b gering. Das Stanzgitter 4 kann sich somit zwischen den Schalen 3, 5 um die Fixierungsbereiche 14 herum verstellen.

In Fig. 3, 4, 5 sind verschiedene Konturierungen der freien Endes 4b gezeigt. Gemäß Fig. 4 verläuft die Leiterbahn 4a bis zum Freiraum 10 in der oberen Platte 5, geht dann in eine 90°- Biegung 15a nach unten (in Fig. 4 somit nach oben) über mit einem ersten Radius, führt dann eine 180 °- Biegung 15b nach oben in den Freiraum 10 bzw. durch den Freiraum 10 hindurch mit einem kleinerem Radius, woraufhin sich gemäß Fig. 4 ein lateraler, d.h. im Wesentlichen in horizontaler Richtung erstreckender Abschnitt 15c anschließt, bei dem gemäß Fig. 4 die verprägte metallische Leiterbahn des freien Endes 4b in vertikaler Richtung verläuft, d.h. gegenüber dem horizontalen Lauf der Leiterbahnen 4a abgewinkelt. Der Abschnitt 15c geht in die darauf folgende 90 °-Biegung 15d über, so dass die geprägte Leiterbahn anschließend z.B. wieder horizontal oder gegenüber der Horizontalen etwas schräg verläuft, mit einer anschließenden Gegen-Biegung 15e, worauf sich die Kontaktfläche 12 anschließt, die verbreitet ist zur besseren Kontaktierung. Die Kontaktfläche 12 kann an ihrem oberen - in Fig. 4 somit unteren-Bereich z.B. etwas abgewinkelt sein. Auf der Kontaktfläche 12 können z.B. Schweißbuckel 17 für das nachfolgende Widerstandsschweißen ausgebildet sein.

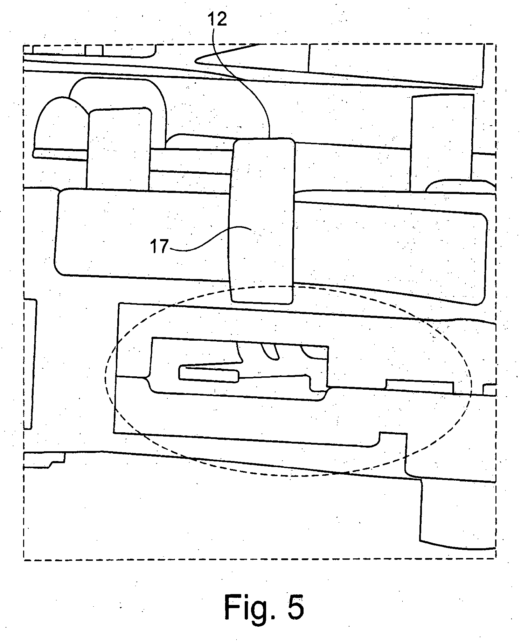

Fig. 3 zeigt eine weitere Ausführungsform, bei der die Leiterbahn 4a nach ihrer Fixierung 14 zunächst in der Ebene der oberen Schale 5 mit Abwinklungen verläuft und sich nachfolgend als freies Ende 4b horizontal unterhalb des Freiraums 10 erstreckt, wo zwei Stege 16, z. B. parallel abgewinkelt von der Leiterbahn 4a verlaufen und mit einer 90°-Biegung 15f nach oben durch den Freiraum 10 der oberen Platte 5 verlaufen, wobei sich an ihrem oberen Ende die Kontaktflächen 12 anschließen; Figur 5 entspricht dieser Ausführungsform.

Somit können die freien Enden 4b jeweils durch nachträgliches Biegen des zunächst planen Stanzgitters 4 ausgebildet werden. Das Biegen der freien Enden 4b kann bereits während des Stanzvorgangs aus dem Metallblech als separater Biegeprozess, oder auch während des Verprägens der beiden Schalen 3, 5 erfolgen.

Die gezeigten Konturierungen der freien Enden 4b ermöglichen somit eine Nachgiebigkeit in den drei Raumrichtüngen, sowohl bei der Kontaktierung als auch Belastungen im nachfolgenden Betrieb.

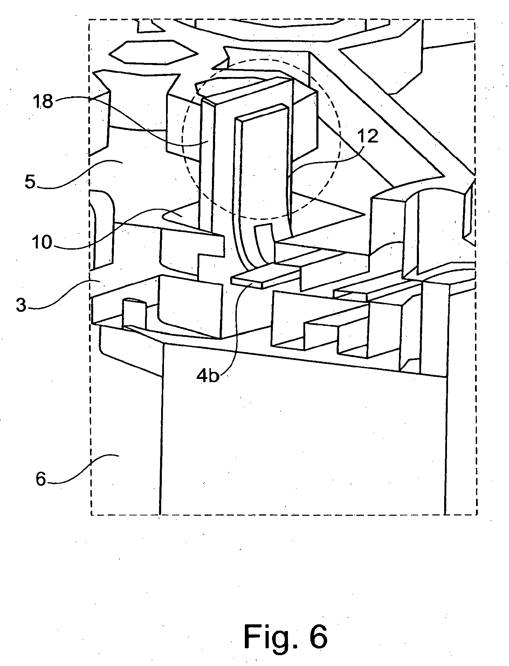

Auf dem in Figur 1 gezeigten Steuerungsgehäuse 2 werden Magnetventile 6 und Sensoren 7 montiert bzw. vormontiert, zum Teil über die Schrauben 8 und/oder über Steckkontakte. Nachfolgend wird das erfindungsgemäße, oben beschriebene Kontaktierungsmodul 1 aufgesetzt. Es wird gemäß Figur 1 vorteilhafterweise sowohl auf dem Steuerungsgehäuse 2 als auch auf den Komponenten, d. h. den Magnetventilen 6 und dem Sensor 7, befestigt und z. B. wiederum über Schrauben 8. Die Schrauben 8 können somit sowohl zur Befestigung des Kontaktierungsmoduls 1 am Steuerungsgehäuse 2 als auch an den Komponenten 6, 7 dienen. Hierbei ragen gemäß Figur 1 die Kontaktflächen 12 der freien Enden 4b nach oben aus den Freiräumen 10, wobei beim Montieren die Kontaktzungen 18 gemäß Figur 6 durch die Freiräume 10 der Schalen 3, 5 gelangen und anschließend parallel und etwas beabstandet zu den Kontaktflächen 12 der freien Enden 4b verlaufen. Der Schweißbuckel 17 liegt hierbei an der Seite der Kontaktfläche 12, der der Kontaktzunge der Komponente 6 oder 7 zugewandt ist. Figur 6 zeigt somit den Kontaktierungsbereich zwischen der Kontaktfläche 12 und der Kontaktzunge 18 für die nachfolgende stoffschlüssige und/oder formschlüssige Verbindüng.

Bei der gezeigten Ausführungsform erfolgt die Kontaktierung mittels einer Schweißverbindung, insbesondere einer Widerstandsschweißverbindung verbunden. Hierzu verfährt in Figur 1 von oben ein Schweißgerät die beiden Schweißpartner 18, 12 in den jeweiligen Freiräumen 10 ab, drückt die Kontaktzunge 18 und Kontaktflächen 12 jeweils zusammen und verschweißt sie miteinander. Alternativ hierzu sind auch formschlüssige Verbindungen durch entsprechende Einrastungen, ggf. auch Verbindungen über ein geeignetes Lot, insbesondere ein Hochtemperatur-Lot, oder auch Leitkleber möglich.

Nachfolgend wird das Steuergerät (ECU) auf das Kontaktierungsmodul 1 von oben draufgesetzt, wozu es z. B. eine geeignete Steckleiste aufweist, mit der es auf eine im mittleren rechten Bereich ausgebildete Steckaufnahme 20 des Kontaktierungsmoduls 1 aufgesetzt wird. Somit ist das erfindungsgemäße Getriebesteuerungsmodul 22 ausgebildet, das nachfolgend an das betreffende Getriebe angesetzt wird.

In Figur 2 sind in an sich bekannter Weise Kolben 24 und Lufteingänge und -auslässe 25, 26 für die pneumatische Steuerung vorgesehen.

## Patentansprüche

1. Kontaktierungsmodul für eine Getriebesteuerung, das aufweist:
ein Modulgehäuse (3, 5), und ein Stanzgitter (4) aus Metall, das in dem Modulgehäuse (3, 5) aufgenommen ist und mehrere Leiterbahnen (4a) mit freien Enden (4b) aufweist, wobei an den freien Enden (4b) Kontaktflächen (12) zur Kontaktierung mit entsprechenden Kontaktzungen von Komponenten, d. h. Magnetventile und gegebenenfalls Sensoren ausgebildet sind, **dadurch gekennzeichnet, dass** in dem Modulgehäuse (3, 5) Freiräume (10) ausgebildet sind, die sich in einer vertikalen Richtung (v) durch das Modulgehäuse (3, 5) erstrecken,
zumindest einige der freien Enden (4b) zumindest teilweise in den Freiräumen (10) angeordnet sind,
die Kontaktflächen (12) zumindest einiger der freien Enden (4b) im Wesentlichen in vertikaler Richtung (v) verlaufen, und
zumindest einige der freien Enden (4b) zumindest im Bereich ihrer Kontaktflächen (12) elastisch nachgiebig ausgebildet sind, so dass Kontaktzungen der Komponenten und die freien Enden der Stanzgitter nachfolgend durch z. B. ein Widerstandsschweißgerät zusammengedrückt und miteinander kontaktiert werden können.

2. Kontaktierungsmodul nach Anspruch 1, **dadurch gekennzeichnet, dass** die freien Enden (4b) zumindest im Bereich ihrer Kontaktflächen (12) aus dem Gehäuse (3, 5) in vertikaler Richtung (V) hervorragen.

3. Kontaktierungsmodul nach Anspruch 1 oder 2, **dadurch gekennzeichnet, dass** zumindest einige der freien Enden (4b) einen mehrfach gekrümmten Verlauf (15a, b, c, d) aufweisen.

4. Kontaktierungsmodul nach einem der vorherigen Ansprüche, **dadurch gekennzeichnet, dass** zumindest einige der freien Enden (4b) in ihren jeweiligen Freiräumen (10) eine Biegung in vertikaler Richtung (v) aus der horizontalen Ebene des Stanzgitters (4) heraus aufweisen.

5. Kontaktierungsmodul nach Anspruch 4, **dadurch gekennzeichnet, dass** zumindest einige der freien Enden (4b) ganz oder teilweise durch Biegungen und/oder gekrümmte Verläufe der jeweiligen Leiterbahnen (4a) mit verbreiterter Ausbildung in ihren Kontaktflächen (12) ausgebildet sind.

6. Kontaktierungsmodul nach einem der vorherigen Ansprüche, **dadurch gekennzeichnet, dass** zumindest einige der freien Enden (4b) von der jeweiligen Leiterbahn (4a) abgehende, parallele Stege (16) aufweisen, die gekrümmt und/oder gebogen sind.

7. Kontaktierungsmodul nach einem der Ansprüche 4 bis 6, **dadurch gekennzeichnet, dass** das Stanzgitter (4) nur in den freien Enden (4b) gebogen und ansonsten plan ausgebildet ist.

8. Kontaktierungsmodul nach einem der vorherigen Ansprüche, **dadurch gekennzeichnet, dass** das Gehäuse (3, 5) eine obere Schale (5) und eine untere Schale (3) aufweist, die miteinander verbunden, z. B. verrastet und/oder verschweißt sind, und das Stanzgitter (4) zwischen den beiden Schalen (3, 5) aufgenommen ist,
wobei in den beiden Schalen (3, 5) die miteinander fluchtenden, vertikalen Freiräume (10) ausgebildet sind.

9. Kontaktierungsmodul nach Anspruch 8, **dadurch gekennzeichnet, dass** das Stanzgitter (4) an zumindest einer der beiden Schalen (3, 5) in Fixierungen (14) durch mechanische Verprägurigen, z. B. vorragende Prägestifte (14), mechanisch fixiert ist.

10. Kontaktierungsmodul nach Anspruch 9, **dadurch gekennzeichnet, dass** das Stanzgitter (4) im Bereich seiner freien Enden (4b) ohne Fixierung aufgenommen und hierdurch in der horizontalen Ebene zwischen den Schalen (3, 5) elastisch verstellbar ist.

11. Kontaktierungsmodul nach einem der vorherigen Ansprüche, **dadurch gekennzeichnet, dass** die freien Enden (4b) zumindest im Bereich ihrer Kontaktflächen (1-2) dreidimensional elastisch verstellbar sind.

12. Getriebesteuerungsmodul (22) für ein Fahrzeuggetriebe, wobei das Getriebesteuerungsmodul (22) mindestens aufweist:
ein Kontaktierungsmodul (1) nach einem der vorherigen Ansprüche, ein Steuerungsgehäuse (2), in dem pneumatische Zylinder und Kolben (24) und Luftein- und Luftauslässe (25, 26) ausgebildet sind, und Magnetventile (6), deren Kontaktzungen (18) mit freien Enden (4b) des Stanzgitters (4) kontaktiert sind,
zumindest einen Sensor (7), der an dem Steuerungsgehäuse (2) befestigt und mit dem Stanzgitter (4) kontaktiert ist, und
eine elektronische Steuereinrichtung, die auf das Kontaktierungsmodul (1) aufgesteckt und mit diesem kontaktiert ist,
wobei das Kontaktierungsmodul (1) an dem Steuerungsgehäuse (2) befestigt ist.

13. Verfahren zum Herstellen eines Kontaktierungsmoduls nach einem der Ansprüche 1 bis 11, mit mindestens folgenden Schritten:
Ausbilden eines Stanzgitters (4) mit Leiterbahnen (4a) und freien Enden (4b), wobei zumindest einige freie Enden (4b) in der vertikalen Stanzrichtung (v) gebogen werden,
Einlegen des Stanzgitters (4) in eine Schale (3, 5) und mechanische Fixierung durch Verprägen der Schale (3, 5),
Zusammensetzen und Verbinden der Schale (3, 5) mit einer weiteren Schale (5, 3) zu einem Gehäuse, in dem in vertikaler Richtung (v) durchgängige Freiräume (10) ausgebildet sind, in denen zumindest einige der freien Enden (4b) des Stanzgitters angeordnet sind.

14. Verfahren zum Herstellen eines Getriebesteuerungsmodul (22) für ein Fahrzeuggetriebe nach Anspruch 12, bei dem
das Kontaktierungsmodul (1) auf ein Steuerungsgehäuse (2) mit vormontierten Magnetventilen und mindestens einem Sensor (7) aufgesetzt wird derartig, dass Kontaktzungen (18) der Magnetventile und/oder des Sensors (7) mit freien Enden (4b) des Stanzgitters (4) gemeinsam durch Freiräume (10) des Kontaktierungsmoduls (1) ragen,
nachfolgend die freien Enden (4b) und die Kontaktzungen (18) zusammengedrückt und miteinander verschweißt werden, vorzugsweise durch ein Widerstandsschweißgerät.

## Claims

1. Contact-making module for a transmission controller, which has:
a module housing (3, 5), and a punched grill (4) made of metal, which is accommodated in the module housing (3, 5), and has a plurality of conductor tracks (4a) with free ends (4b), wherein contact faces (12) for making contact with corresponding contact tongues of components, i.e. the Solenoid valves and, if appropriate, sensors, are formed at the free ends (4b),
**characterized in that**
free spaces (10), which extend in a vertical direction (v) through the module housing (3, 5), are formed in the module housing (3, 5),
at least some of the free ends (4b) are arranged at least partially in the free spaces (10),
the contact faces (12) of at least some of the free ends (4b) run essentially in the vertical direction (v), and
at least some of the free ends (4b) are of elastically resilient design, at least in the region of their contact faces (12), with the result that contact tongues of the components and the free ends of the punched grill can subsequently be compressed, for example by a resistance welding device, and placed in contact with one another.

2. Contact-making module according to Claim 1, **characterized in that** the free ends (4b) project out of the housing (3, 5) in the vertical direction (V) at least in the region of the contact faces (12) of said free ends (4b).

3. Contact-making module according to Claim 1 or 2, **characterized in that** at least some of the free ends (4b) have a multiply curved profile (15a, b, c, d).

4. Contact-making module according to one of the preceding claims, **characterized in that** at least some of the free ends (4b) have, in their respective free spaces (10), a bend in the vertical direction (v) out of the horizontal plane of the punched grill (4).

5. Contact-making module according to Claim 4, **characterized in that** at least some of the free ends (4b) are formed entirely or partially by bends and/or curved profiles of the respective conductor tracks (4a) with a widened formation in their contact faces (12).

6. Contact-making module according to one of the preceding claims, **characterized in that** at least some of the free ends (4b) have parallel webs (16) which protrude from the respective conductor track (4a) and are curved and/or bent.

7. Contact-making module according to one of Claims 4 to 6, **characterized in that** the punched grill (4) is bent only at the free ends (4b) and is otherwise of planar design.

8. Contact-making module according to one of the preceding claims, **characterized in that** the housing (3, 5) has an upper shell (5) and a lower shell (3) connected to one another, for example latched and/or welded, and the punched grill (4) is accommodated between the two shells (3, 5), wherein vertical free spaces (10) are formed in the two shells (3, 5) which are aligned with one another.

9. Contact-making module according to Claim 8, **characterized in that** the punched grill (4) is mechanically secured to at least one of the two shells (3, 5) in attachments (14) by means of mechanical stamped elements, for example projecting stamped pins (14).

10. Contact-making module according to Claim 9, **characterized in that** the punched grill (4) is accommodated in the region of its free ends (4b) without an attachment and as a result is elastically adjustable between the shells (3, 5) in the horizontal plane.

11. Contact-making module according to one of the preceding claims, **characterized in that** the free ends (4b) are elastically adjustable in three dimensions at least in the region of their contact faces (12).

12. Transmission control module (22) for a vehicle transmission, wherein the transmission control module (22) has at least:
a contact-making module (1) according to one of the preceding claims,
a control housing (2) in which pneumatic cylinders and pistons (24) and air inlets and air outlets (25, 26) are formed, and
solenoid valves (6) whose contact tongues (18) are placed in contact with free ends (4b) of the punched grill (4), at least one sensor (7) which is attached to the control housing (2) and is placed in contact with the punched grill (4), and
an electronic control device which is plugged onto the contact-making module (1) and placed in contact therewith,
wherein the contact-making module (1) is attached to the control housing (2).

13. method for manufacturing a contact-making module according to one of Claims 1 to 11, having at least the following steps:
formation of a punched grill (4) with conductor tracks (4a) and free ends (4b), wherein at least some of the free ends (4b) are bent in the vertical punching direction (v),
insertion of the punched grill (4) into a shell (3, 5), and mechanical securement by stamping the shell (3, 5).
combination and connection of the shell (3, 5) with a further shell (5, 3) to form a housing in which free spaces (10) which are continuous in the vertical direction (v) are formed, in which free spaces (10) at least some of the free ends (4b) of the punched grill are arranged.

14. Method for manufacturing a transmission control module (22) for a vehicle transmission according to Claim 12, in which
the contact-making module (1) is fitted onto a control housing (2) with pre-mounted solenoid valves and at least one sensor (7), in such a way that contact tongues (18) of the solenoid valves and/or of the sensor (7) project jointly with free ends (4b) of the punched grill (4) through free spaces (10) of the contact-making module (1), and the free ends (4b) and the contact tongues (18) are subsequently compressed and welded to one another, preferably by means of a resistance welding device.

## Revendications

1. Module de mise en contact pour une commande de boîte de vitesses, qui présente:
un boîtier de module (3, 5), et une grille estampée (4) en métal, qui est logée dans le boîtier de module (3, 5) et présente plusieurs voies conductrices (4a) avec des extrémités libres (4b), dans lequel des faces de contact (12) sont formées aux extrémités libres (4b) pour la mise en contact avec des lamelles de contact correspondantes de composants, c'est-à-dire de soupapes magnétiques et éventuellement de capteurs,
**caractérisé en ce que** des espaces libres (10), qui s'étendent en direction verticale (v) à travers le boîtier de module (3, 5), sont formés à travers le boîtier de module (3, 5),
au moins certaines des extrémités libres (4b) sont disposées au moins partiellement dans ces espaces libres (10),
les faces de contact (12) d'au moins certaines extrémités libres (4b) s'étendent essentiellement en direction verticale (v), et
au moins certaines des extrémités libres (4b) sont réalisées sous forme déformable élastiquement au moins dans la région de leurs faces de contact (12), de telle manière que des lamelles de contact des composants et les extrémités libres de la grille estampée puissent ensuite être comprimées par exemple par un appareil de soudage par résistance et mises en contact les unes avec les autres.

2. Module de mise en contact selon la revendication 1, **caractérisé en ce que** les extrémités libres (4b) sont saillantes en direction verticale (v) hors du boîtier (3, 5) au moins dans la région de leurs faces de contact (12).

3. Module de mise en contact selon la revendication 1 ou 2, **caractérisé en ce qu'**au moins certaines des extrémités libres (4b) présentent un tracé plusieurs fois incurvé (15a, b, c, d).

4. Module de mise en contact selon l'une quelconque des revendications précédentes, **caractérisé en ce qu'**au moins certaines des extrémités libres (4b) présentent dans leurs espaces libres respectifs (10) une courbure en direction verticale (v) hors du plan horizontal de la grille estampée (4).

5. Module de mise en contact selon la revendication 4, **caractérisé en ce qu'**au moins certaines des extrémités libres (4b) sont formées entièrement ou partiellement par des courbes et/ou des tracés incurvés des voies conductrices respectives (4a) avec une configuration élargie dans leurs faces de contact (12).

6. Module de mise en contact selon l'une quelconque des revendications précédentes, **caractérisé en ce qu'**au moins certaines des extrémités libres (4b) présentent des nervures parallèles (16), saillantes sur la voie conductrice respective (4a), qui sont incurvées et/ou courbées.

7. Module de mise en contact selon l'une quelconque des revendications 4 à 6, **caractérisé en ce que** la grille estampée (4) n'est courbée que dans les extrémités libres (4b) et est pour le reste plane.

8. Module de mise en contact selon l'une quelconque des revendications précédentes, **caractérisé en ce que** le boîtier (3, 5) présente une coquille supérieure (5) et une coquille inférieure (3), qui sont assemblées l'une à l'autre, par exemple encliquetées et/ou soudées, et la grille estampée (4) est placée entre les deux coquilles (3, 5), dans lequel des espaces libres verticaux (10) sont formés dans les deux coquilles (3, 5), qui sont alignées l'une avec l'autre.

9. Module de mise en contact selon la revendication 8, **caractérisé en ce que** la grille estampée (4) est fixée mécaniquement à au moins une des deux coquilles (3, 5) dans des fixations (14) par des empreintes mécaniques, par exemple par des tiges embouties saillantes (14).

10. Module de mise en contact selon la revendication 9, **caractérisé en ce que** la grille estampée (4) est logée dans la région de ses extrémités libres (4b) sans fixations et est ainsi déplaçable élastiquement dans le plan horizontal entre les coquilles (3, 5).

11. Module de mise en contact selon l'une quelconque des revendications précédentes, **caractérisé en ce que** les extrémités libres (4b) sont déplaçables élastiquement en trois dimensions au moins dans la région de leurs faces de contact (12).

12. Module de commande de boîte de vitesses (22) pour une boîte de vitesses de véhicule, dans lequel le module de commande de boîte de vitesses (22) présente au moins:
un module de mise en contact (1) selon l'une quelconque des revendications précédentes,
un boîtier de commande (2), dans lequel des cylindres pneumatiques et des pistons (24) et des entrées et des sorties d'air (25, 26) sont formés, et
des soupapes magnétiques (6), dont les lamelles de contact (18) sont mises en contact avec des extrémités libres (4b) de la grille estampée (4),
au moins un capteur (7), qui est fixé sur le boîtier de commande (2) et qui est mis en contact avec la grille estampée (4), et
un dispositif de commande électronique, qui est engagé sur le module de mise en contact (1) et qui est mis en contact avec celui-ci,
dans lequel le module de mise en contact (1) est fixé sur le boîtier de commande (2).

13. Procédé de fabrication d'un module de mise en contact selon l'une quelconque des revendications 1 à 11, comprenant au moins les étapes suivantes:
formation d'une grille estampée (4) avec des voies conductrices (4a) et des extrémités libres (4b), dans lequel on courbe au moins certaines des extrémités libres (4b) dans la direction d'estampage verticale (v),
insertion de la grille estampée (4) dans une coquille (3, 5) et fixation mécanique par gaufrage de la coquille (3, 5),
jonction et assemblage de la coquille (3, 5) avec une coquille (5, 3) en un boîtier, dans lequel des espaces libres (10) traversants en direction verticale (v) sont formés, dans lesquels au moins certaines des extrémités libres (4b) de la grille estampée sont disposées.

14. Procédé de fabrication d'un module de commande de boîte de vitesses (22) pour une boîte de vitesses de véhicule selon la revendication 12, dans lequel le module de mise en contact (1) est posé sur un module de commande (2) avec des soupapes magnétiques et au moins un capteur (7) pré-montés, de telle manière que des lamelles de contact (18) des soupapes magnétiques et/ou du capteur (7) sortent en même temps que des extrémités libres (4b) de la grille estampée (4) à travers des espaces libres (10) du module de mise en contact (1),
les extrémités libres (4b) et les lamelles de contact (18) sont ensuite comprimées et soudées les unes aux autres, de préférence au moyen d'un appareil de soudage par résistance.
